# EUROPEAN PATENT APPLICATION

(11) **EP 4 024 455 A1**
(43) Date of publication of application: **06.07.2022**
(21) Application number: 20862677.0
(22) Date of filing: 11.09.2020
(51) Int. Cl.: H01L 25/18, H01L 25/07

(54) **DISCRETE DIODE DEVICE, CIRCUIT HAVING BYPASS FUNCTION, AND CONVERTER**

(30) Priority: 12.09.2019 CN 201910867046
(71) Applicant: Huawei Digital Power Technologies Co., Ltd., Shenzhen, Guangdong 518043 (CN)
(72) Inventor: CHEN, Dong, Shenzhen, Guangdong 518129 (CN); SHI, Lei, Shenzhen, Guangdong 518129 (CN); WANG, Zhaohui, Shenzhen, Guangdong 518129 (CN)
(74) Representative: Goddar, Heinz J.
(86) International application number: PCT/CN2020/114786
(87) International publication number: WO 2021/047638

(57) **Abstract**

This application provides a diode discrete device, a circuit with a bypass function, and a converter. The diode discrete device is used in a circuit with a bypass function, and the diode discrete device includes a discrete device package, a first diode, and a second diode. The first diode is a main circuit diode, the second diode is a bypass diode, first performance of the first diode is better than first performance of the second diode, and the first performance includes a reverse recovery charge and reverse recovery time. The first diode and the second diode are packaged into the discrete device package, and an anode of the first diode is connected to an anode of the second diode, or a cathode of the first diode is connected to a cathode of the second diode. The diode discrete device can improve integration and power density of the circuit.

## Description

This application claims priority to Chinese Patent Application No. 201910867046.6, filed with the China National Intellectual Property Administration on September 12, 2019 and entitled "DIODE DISCRETE DEVICE, CIRCUIT WITH BYPASS FUNCTION, AND CONVERTER", which is incorporated herein by reference in its entirety.

### TECHNICAL FIELD

This application relates to the circuit field, and more specifically, to a diode discrete device, a circuit with a bypass function, and a converter.

### BACKGROUND

A boost (boost) circuit (or referred to as a boost (boost) circuit) is used in a photovoltaic system, and can convert a wide-range direct current voltage output by a photovoltaic module into a stable direct current voltage, to meet a later-stage inverter circuit. When an output voltage of the photovoltaic module is higher than a direct current voltage level requirement of the inverter circuit, an active switching device of the boost (boost) circuit does not perform a switching action. In this case, an output current of the photovoltaic module flows through a main inductor and a main circuit diode of the boost (boost) circuit, causing a loss.

Because conduction performance and switching performance of the main circuit diode of the boost (boost) circuit need to be comprehensively considered, a conduction voltage drop of the main circuit diode of the boost (boost) circuit is usually relatively large, and correspondingly a conduction loss of the circuit is also relatively large. In this case, a bypass function is added to the boost (boost) circuit, so that the conduction loss of the circuit can be effectively reduced. However, when the bypass function is added, an area and a volume of the circuit also increase, and consequently integration and power density of the circuit are reduced.

Therefore, how to improve integration and power density of a circuit becomes a technical problem that needs to be resolved urgently.

### SUMMARY

This application provides a diode discrete device, a circuit with a bypass function, and a converter, to improve integration and power density of a circuit.

According to a first aspect, a diode discrete device is provided. The diode discrete device is used in a circuit with a bypass function, and the diode discrete device includes a discrete device package body, a first diode, and a second diode. The first diode is a main circuit diode, the second diode is a bypass diode, first performance of the first diode is better than first performance of the second diode, and the first performance includes a reverse recovery charge and reverse recovery time. The first diode and the second diode are packaged into the discrete device package body, and an anode of the first diode is connected to an anode of the second diode, or a cathode of the first diode is connected to a cathode of the second diode.

In this embodiment of this application, two diodes with different performance are packaged into one discrete device package body, so that an area and a volume of a circuit can be reduced, thereby improving integration and power density of the circuit.

In addition, two diodes with different performance are packaged into one discrete device package body, so that one discrete device package can be saved, thereby reducing packaging costs.

Further, when the diode discrete device in this embodiment of this application is used in the circuit with the bypass function, only one diode causes a loss at a same moment. Therefore, a heat dissipation requirement can be met by using a heat sink corresponding to a single discrete device package, so that a size of the heat sink is reduced, and utilization of the heat sink can be improved, thereby further reducing costs.

It should be noted that the first performance is switching performance of the diode.

With reference to the first aspect, in some implementations of the first aspect, the first diode is a wide-bandgap semiconductor device, and the second diode is a silicon-based semiconductor device.

With reference to the first aspect, in some implementations of the first aspect, the wide-bandgap semiconductor device is a silicon carbide semiconductor device, or the wide-bandgap semiconductor device is a gallium nitride semiconductor device.

With reference to the first aspect, in some implementations of the first aspect, both the first diode and the second diode are silicon-based semiconductor devices.

For example, the first diode may be a silicon-based fast recovery diode, and the second diode may be a silicon-based rectifier diode.

Optionally, the first performance may further include a reverse recovery current.

With reference to the first aspect, in some implementations of the first aspect, second performance of the second diode is better than second performance of the first diode, and the second performance includes at least one of a withstand voltage level, a conduction voltage drop, and a withstand current level.

In this embodiment of this application, when a bypass of the circuit works, the bypass diode is forward conducted. Therefore, if a conduction voltage drop of the second diode is better than a conduction voltage drop of the first diode, a loss is relatively low when the bypass of the circuit works.

With reference to the first aspect, in some implementations of the first aspect, the diode discrete device includes at least three electrodes.

With reference to the first aspect, in some implementations of the first aspect, the anode of the first diode and the anode of the second diode are connected to each other inside the discrete device package body; the cathode of the first diode and the cathode of the second diode are connected to each other inside the discrete device package body; the anode of the first diode and the anode of the second diode are connected to each other outside the discrete device package body; or the cathode of the first diode and the cathode of the second diode are connected to each other outside the discrete device package body.

With reference to the first aspect, in some implementations of the first aspect, the discrete device package body is a TO-247 package, the discrete device package body is a TO-220 package, the discrete device package body is a TO-263 package, or the discrete device package body is a TO-252 package.

According to a second aspect, a circuit with a bypass function is provided. The circuit includes a main circuit, a bypass, and a diode discrete device used in the circuit. The diode discrete device includes a discrete device package body, a first diode, and a second diode, the first diode is connected to the main circuit, and the second diode is connected to the bypass. First performance of the first diode is better than first performance of the second diode, and the first performance includes a reverse recovery charge and reverse recovery time. The first diode and the second diode are packaged into the discrete device package body, and an anode of the first diode is connected to an anode of the second diode, or a cathode of the first diode is connected to a cathode of the second diode.

In this embodiment of this application, two diodes with different performance are packaged into one discrete device package body, so that an area and a volume of a circuit can be reduced, thereby improving integration and power density of the circuit.

In addition, two diodes with different performance are packaged into one discrete device package body, so that one discrete device package can be saved, thereby reducing packaging costs.

Further, when the diode discrete device in this embodiment of this application is used in the circuit with the bypass function, only one diode causes a loss at a same moment. Therefore, a heat dissipation requirement can be met by using a heat sink corresponding to a single discrete device package, so that a size of the heat sink is reduced, and utilization of the heat sink can be improved, thereby further reducing costs.

It should be noted that the first performance is switching performance of the diode.

With reference to the second aspect, in some implementations of the second aspect, the first diode is a wide-bandgap semiconductor device, and the second diode is a silicon-based semiconductor device.

With reference to the second aspect, in some implementations of the second aspect, the wide-bandgap semiconductor device is a silicon carbide semiconductor device, or the wide-bandgap semiconductor device is a gallium nitride semiconductor device.

With reference to the second aspect, in some implementations of the second aspect, both the first diode and the second diode are silicon-based semiconductor devices.

For example, the first diode may be a silicon-based fast recovery diode, and the second diode may be a silicon-based rectifier diode.

Optionally, the first performance may further include a reverse recovery current.

With reference to the second aspect, in some implementations of the second aspect, second performance of the second diode is better than second performance of the first diode, and the second performance includes at least one of a withstand voltage level, a conduction voltage drop, and a withstand current level.

In this embodiment of this application, when the bypass of the circuit works, a bypass diode is forward conducted. Therefore, if a conduction voltage drop of the second diode is better than a conduction voltage drop of the first diode, a loss is relatively low when the bypass of the circuit works.

With reference to the second aspect, in some implementations of the second aspect, the diode discrete device includes at least three electrodes.

With reference to the second aspect, in some implementations of the second aspect, the anode of the first diode and the anode of the second diode are connected to each other inside the discrete device package body; the cathode of the first diode and the cathode of the second diode are connected to each other inside the discrete device package body; the anode of the first diode and the anode of the second diode are connected to each other outside the discrete device package body; or the cathode of the first diode and the cathode of the second diode are connected to each other outside the discrete device package body.

With reference to the second aspect, in some implementations of the second aspect, the discrete device package body is a TO-247 package, the discrete device package body is a TO-220 package, the discrete device package body is a TO-263 package, or the discrete device package body is a TO-252 package.

According to a third aspect, a converter is provided. The converter includes at least one diode discrete device, and the diode discrete device includes a discrete device package body, a first diode, and a second diode. The first diode is a main circuit diode, the second diode is a bypass diode, first performance of the first diode is better than first performance of the second diode, and the first performance includes a reverse recovery charge and reverse recovery time. The first diode and the second diode are packaged into the discrete device package body, and an anode of the first diode is connected to an anode of the second diode, or a cathode of the first diode is connected to a cathode of the second diode.

In this embodiment of this application, two diodes with different performance are packaged into one discrete device package body, so that an area and a volume of a circuit can be reduced, thereby improving integration and power density of the circuit.

In addition, two diodes with different performance are packaged into one discrete device package body, so that one discrete device package can be saved, thereby reducing packaging costs.

Further, when the diode discrete device in this embodiment of this application is used in a circuit with a bypass function, only one diode causes a loss at a same moment. Therefore, a heat dissipation requirement can be met by using a heat sink corresponding to a single discrete device package, so that a size of the heat sink is reduced, and utilization of the heat sink can be improved, thereby further reducing costs.

It should be noted that the first performance is switching performance of the diode.

With reference to the third aspect, in some implementations of the third aspect, the first diode is a wide-bandgap semiconductor device, and the second diode is a silicon-based semiconductor device.

With reference to the third aspect, in some implementations of the third aspect, the wide-bandgap semiconductor device is a silicon carbide semiconductor device, or the wide-bandgap semiconductor device is a gallium nitride semiconductor device.

With reference to the third aspect, in some implementations of the third aspect, both the first diode and the second diode are silicon-based semiconductor devices.

For example, the first diode may be a silicon-based fast recovery diode, and the second diode may be a silicon-based rectifier diode.

Optionally, the first performance may further include a reverse recovery current.

With reference to the third aspect, in some implementations of the third aspect, second performance of the second diode is better than second performance of the first diode, and the second performance includes at least one of a withstand voltage level, a conduction voltage drop, and a withstand current level.

In this embodiment of this application, when a bypass of the circuit works, the bypass diode is forward conducted. Therefore, if a conduction voltage drop of the second diode is better than a conduction voltage drop of the first diode, a loss is relatively low when the bypass of the circuit works.

With reference to the third aspect, in some implementations of the third aspect, the diode discrete device includes at least three electrodes.

With reference to the third aspect, in some implementations of the third aspect, the anode of the first diode and the anode of the second diode are connected to each other inside the discrete device package body; the cathode of the first diode and the cathode of the second diode are connected to each other inside the discrete device package body; the anode of the first diode and the anode of the second diode are connected to each other outside the discrete device package body; or the cathode of the first diode and the cathode of the second diode are connected to each other outside the discrete device package body.

With reference to the third aspect, in some implementations of the third aspect, the discrete device package body is a TO-247 package, the discrete device package body is a TO-220 package, the discrete device package body is a TO-263 package, or the discrete device package body is a TO-252 package.

According to a fourth aspect, a discrete device packaging method is provided, including: packaging a first diode and a second diode into a same discrete device package body to obtain a diode discrete device. The first diode is a main circuit diode, the second diode is a bypass diode, first performance of the first diode is better than first performance of the second diode, the first performance includes a reverse recovery charge and reverse recovery time, the first diode and the second diode are packaged into the same discrete device package body, and an anode of the first diode is connected to an anode of the second diode, or a cathode of the first diode is connected to a cathode of the second diode.

In this embodiment of this application, two diodes with different performance are packaged into one discrete device package body, so that an area and a volume of a circuit can be reduced, thereby improving integration and power density of the circuit.

In addition, two diodes with different performance are packaged into one discrete device package body, so that one discrete device package can be saved, thereby reducing packaging costs.

Further, when the diode discrete device in this embodiment of this application is used in a circuit with a bypass function, only one diode causes a loss at a same moment. Therefore, a heat dissipation requirement can be met by using a heat sink corresponding to a single discrete device package, so that a size of the heat sink is reduced, and utilization of the heat sink can be improved, thereby further reducing costs.

It should be noted that the first performance is switching performance of the diode.

With reference to the fourth aspect, in some implementations of the fourth aspect, the first diode is a wide-bandgap semiconductor device, and the second diode is a silicon-based semiconductor device.

With reference to the fourth aspect, in some implementations of the fourth aspect, the wide-bandgap semiconductor device is a silicon carbide semiconductor device, or the wide-bandgap semiconductor device is a gallium nitride semiconductor device.

With reference to the fourth aspect, in some implementations of the fourth aspect, both the first diode and the second diode are silicon-based semiconductor devices.

For example, the first diode may be a silicon-based fast recovery diode, and the second diode may be a silicon-based rectifier diode.

Optionally, the first performance may further include a reverse recovery current.

With reference to the fourth aspect, in some implementations of the fourth aspect, second performance of the second diode is better than second performance of the first diode, and the second performance includes at least one of a withstand voltage level, a conduction voltage drop, and a withstand current level.

In this embodiment of this application, when a bypass of the circuit works, the bypass diode is forward conducted. Therefore, if a conduction voltage drop of the second diode is better than a conduction voltage drop of the first diode, a loss is relatively low when the bypass of the circuit works.

With reference to the fourth aspect, in some implementations of the fourth aspect, the diode discrete device includes at least three electrodes.

With reference to the fourth aspect, in some implementations of the fourth aspect, the anode of the first diode and the anode of the second diode are connected to each other inside the discrete device package body; the cathode of the first diode and the cathode of the second diode are connected to each other inside the discrete device package body; the anode of the first diode and the anode of the second diode are connected to each other outside the discrete device package body; or the cathode of the first diode and the cathode of the second diode are connected to each other outside the discrete device package body.

With reference to the fourth aspect, in some implementations of the fourth aspect, the discrete device package body is a TO-247 package, the discrete device package body is a TO-220 package, the discrete device package body is a TO-263 package, or the discrete device package body is a TO-252 package.

In this embodiment of this application, two diodes with different performance are packaged into one discrete device package body, so that an area and a volume of a circuit can be reduced, thereby improving integration and power density of the circuit.

### BRIEF DESCRIPTION OF DRAWINGS

FIG. 1 is a schematic diagram of a boost (boost) circuit with a bypass function according to an embodiment of this application;
FIG. 2 is a schematic diagram of a diode discrete device according to an embodiment of this application;
FIG. 3 is a schematic diagram of another diode discrete device according to an embodiment of this application;
FIG. 4 is a schematic diagram of still another diode discrete device according to an embodiment of this application;
FIG. 5 is a schematic diagram of a circuit in which a diode discrete device is used according to an embodiment of this application; and
FIG. 6 is a schematic diagram of another circuit in which a diode discrete device is used according to an embodiment of this application.

### DESCRIPTION OF EMBODIMENTS

The following describes technical solutions in this application with reference to accompanying drawings in the embodiments.

Clearly, the described embodiments are merely some but not all of the embodiments of this application. All other embodiments obtained by a person of ordinary skill in the art based on the embodiments of this application without creative efforts shall fall within the protection scope of this application.

An embodiment of this application provides a diode discrete device. The diode discrete device may be applied to various circuits with a bypass function, and the circuit with the bypass function may be a converter or a partial circuit that constitutes a converter system. The converter may be a boost converter (for example, a boost (boost) converter with the bypass function) or a buck converter (for example, a buck (buck) converter with the bypass function), or may be another converter with the bypass function. This is not limited in this embodiment of this application.

It should be noted that, in this embodiment of this application, the boost converter may also be referred to as a boost circuit, the boost (boost) converter may also be referred to as a boost (boost) circuit, the buck converter may also be referred to as a buck circuit, and the buck (buck) converter may also be referred to as a buck (buck) circuit (or referred to as a buck (buck) circuit).

For ease of understanding, the following uses the boost (boost) circuit as an example to describe the diode discrete device in this embodiment of this application. A person skilled in the art may understand that the description in the following embodiments is merely an example rather than a limitation.

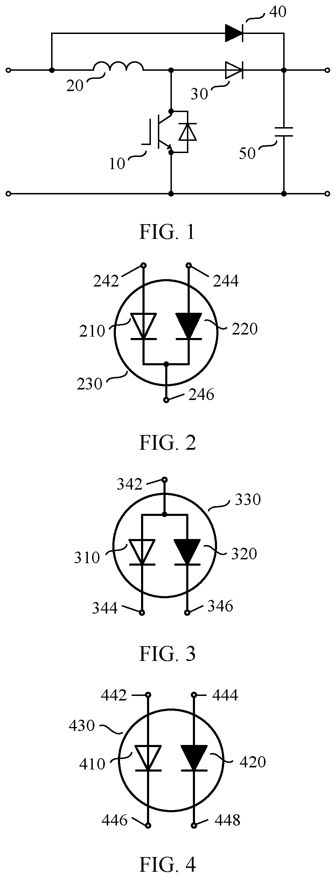

In a conventional technology, to reduce a conduction loss of a boost (boost) circuit when an active switching device does not perform a switching action, a bypass function may be added to the circuit. FIG. 1 shows a boost (boost) circuit 100 with a bypass function.

In FIG. 1, the boost (boost) circuit 100 with the bypass function may include an active switching device 10, an inductor 20, a main circuit diode 30, a bypass diode 40, and a capacitor 50. The active switching device 10 may be an insulated gate bipolar transistor (insulated gate bipolar transistor, IGBT) or a metal-oxide semiconductor field-effect transistor (metal-oxide semiconductor field-effect transistor, MOSFET), and the active switching device 10 may be configured to perform a switching action.

It may be understood by a person skilled in the art that, that the active switching device 10 performs the switching action means that the active switching device 10 repeatedly performs, at a specific frequency, a series of actions "the active switching device 10 is closed for a period of time and then is opened for another period", so that the boost (boost) circuit in FIG. 1 boosts an input voltage, and a main circuit of the boost (boost) circuit is working; and that the active switching device 10 does not perform the switching action means that the active switching device 10 keeps open, so that the bypass diode 40 is forward conducted, and a bypass of the boost (boost) circuit is working.

Although the bypass function is added to the boost (boost) circuit, a diode with a relatively low conduction voltage drop is selected as the bypass diode 40, so that a conduction loss of the circuit can be effectively reduced. However, when the bypass function is added, an area and a volume of the circuit also increase, and consequently integration and power density of the circuit are reduced.

Therefore, an embodiment of this application provides a diode discrete device, to improve integration and power density of a circuit.

The following describes the diode discrete device in this embodiment of this application in detail with reference to FIG. 2, FIG. 3, and FIG. 4. It should be understood that diode discrete devices shown in FIG. 2, FIG. 3, and FIG. 4 are merely examples, and the diode discrete devices each may include more devices or units. In addition, a location of each device or unit in the diode discrete devices shown in FIG. 2, FIG. 3, and FIG. 4 is merely an example rather than a limitation.

The diode discrete device in this embodiment of this application may be used in a circuit with a bypass function, and the diode discrete device may include a discrete device package body, a first diode, and a second diode.

The first diode may be a main circuit diode, the second diode may be a bypass diode, first performance of the first diode may be better than first performance of the second diode, and the first performance includes a reverse recovery charge and reverse recovery time.

It should be noted that the first performance is switching performance of the diode.

Optionally, the first diode may be a wide-bandgap semiconductor device, and the second diode may be a silicon-based semiconductor device.

For example, the wide-bandgap semiconductor device may be a silicon carbide semiconductor device, or the wide-bandgap semiconductor device may be a gallium nitride semiconductor device.

Alternatively, both the first diode and the second diode may be silicon-based semiconductor devices.

For example, the first diode may be a silicon-based fast recovery diode, and the second diode may be a silicon-based rectifier diode.

Optionally, the first diode and the second diode may be packaged into the discrete device package body, and an anode of the first diode may be connected to an anode of the second diode, or a cathode of the first diode may be connected to a cathode of the second diode.

It should be noted that the first diode may include one or more same diodes (or diodes with same performance). For example, the first diode may be a diode formed by connecting a plurality of same diodes (or diodes with same performance) in parallel, or the first diode may be a diode obtained by packaging a plurality of same diodes (or diodes with same performance).

The second diode is similar to the first diode, and may also include one or more same diodes (or diodes with same performance). Details are not described herein again.

In this embodiment of this application, two diodes with different performance are packaged into one discrete device package body, so that an area and a volume of a circuit can be reduced, thereby improving integration and power density of the circuit.

In addition, two diodes with different performance are packaged into one discrete device package body, so that one discrete device package can be saved, thereby reducing packaging costs.

Further, when the diode discrete device in this embodiment of this application is used in the circuit with the bypass function, only one diode causes a loss at a same moment.

Specifically, when a main circuit of the circuit works, an active switching device of the main circuit performs a switching action, the main circuit diode (namely, the first diode of the diode discrete device) passively follows the active switching device to perform the switching action, and the bypass diode (namely, the second diode of the diode discrete device) is reversely cut off. In this case, the main circuit diode causes a loss in the diode discrete device. When a bypass of the circuit works, the active switching device of the main circuit does not perform the switching action, the main circuit diode correspondingly also does not perform the switching action, and the bypass diode is forward conducted. In this case, the bypass diode causes a loss in the diode discrete device.

Therefore, a heat dissipation requirement can be met by using a heat sink corresponding to a single discrete device package, so that a size of the heat sink is reduced, and utilization of the heat sink can be improved, thereby further reducing costs.

Optionally, the first performance may further include a reverse recovery current.

The discrete device package body may be a housing enclosing one or more discrete semiconductor devices (for example, diodes in this embodiment of this application), and a material of the discrete device package body may be metal, plastic, glass, or ceramic, or may be another material. This is not limited in this embodiment of this application.

The discrete device package body may protect the discrete semiconductor device, to reduce impact of mechanical stress, chemical pollution, light source irradiation, and the like on the discrete semiconductor device. In addition, the discrete device package body may further provide a connection path between the discrete semiconductor device inside the discrete device package body and an external circuit of the discrete device package body by using a connection point such as a backplane, a ball point, or a pin.

In this embodiment of this application, the discrete device package body may be a TO-247 package, the discrete device package body may be a TO-220 package, the discrete device package body may be a TO-263 package, or the discrete device package body may be a TO-252 package.

In this embodiment of this application, second performance of the second diode may be better than second performance of the first diode, and the second performance may include at least one of a withstand voltage level, a conduction voltage drop, and a withstand current level.

In this embodiment of this application, when the bypass of the circuit works, the bypass diode is forward conducted. Therefore, if a conduction voltage drop of the second diode is better than a conduction voltage drop of the first diode, a loss is relatively low when the bypass of the circuit works.

For example, a withstand voltage level of the second diode is better than a withstand voltage level of the first diode, a conduction voltage drop of the second diode is better than a conduction voltage drop of the first diode, and a withstand current level of the second diode is better than a withstand current level of the first diode.

For another example, a withstand voltage level of the second diode is the same as a withstand voltage level of the first diode, but a conduction voltage drop of the second diode is better than a conduction voltage drop of the first diode, and a withstand current level of the second diode is better than a withstand current level of the first diode.

In this embodiment of this application, the diode discrete device may include at least three electrodes.

For example, FIG. 2 is a schematic structural diagram of a diode discrete device 200 according to an embodiment of this application.

The diode discrete device 200 in FIG. 2 includes a first diode 210, a second diode 220, and a discrete device package body 230. The diode discrete device 200 includes three electrodes: an anode 242, an anode 244, and a cathode 246.

As shown in FIG. 2, a cathode of the first diode 210 and a cathode of the second diode 220 may be connected to each other inside the discrete device package body 230, and a cathode obtained after the connection is the cathode 246.

FIG. 3 is a schematic structural diagram of a diode discrete device 300 according to another embodiment of this application.

The diode discrete device 300 in FIG. 3 includes a first diode 310, a second diode 320, and a discrete device package body 330. The diode discrete device 300 includes three electrodes: an anode 342, a cathode 344, and a cathode 346.

As shown in FIG. 3, an anode of the first diode 310 and an anode of the second diode 320 may be connected to each other inside the discrete device package body 330, and an anode obtained after the connection is the anode 342.

For another example, FIG. 4 is a schematic structural diagram of a diode discrete device 400 according to still another embodiment of this application.

The diode discrete device 400 in FIG. 4 includes a first diode 410, a second diode 420, and a discrete device package body 430. The diode discrete device 400 includes fourth electrodes: an anode 442, an anode 444, a cathode 446, and a cathode 448.

Optionally, the anode 442 of the first diode 410 and the anode 444 of the second diode 420 that are shown in FIG. 4 may be connected to each other outside the discrete device package body 430.

Optionally, the cathode 446 of the first diode 410 and the cathode 448 of the second diode 420 that are shown in FIG. 4 may be connected to each other outside the discrete device package body 430.

In this embodiment of this application, the diode discrete device may alternatively include more than four electrodes. This is not limited in this embodiment of this application.

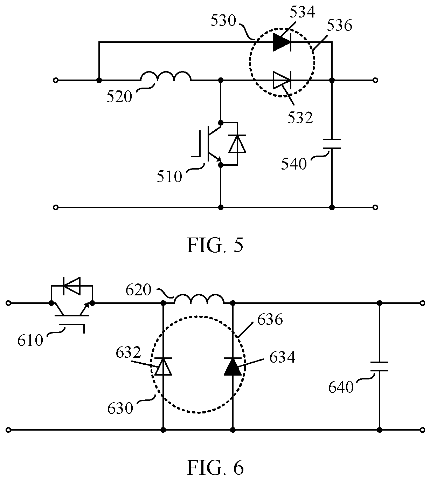

The diode discrete devices shown in FIG. 2, FIG. 3, and FIG. 4 each may be used in circuits with the bypass function, for example, a boost (boost) circuit and a buck (buck) circuit. With reference to FIG. 5 and FIG. 6, the following describes application of the diode discrete device in this embodiment of this application to a boost (boost) circuit and a buck (buck) circuit.

It should be understood that FIG. 5 and FIG. 6 are merely examples rather than limitations. The diode discrete device in this embodiment of this application may be alternatively used in another circuit with a bypass function. This is not limited in this embodiment of this application.

FIG. 5 shows a boost (boost) circuit 500 with a bypass function according to an embodiment of this application. The circuit 500 may include an active switching device 510, an inductor 520, a diode discrete device 530, and a capacitor 540. The diode discrete device 530 may be the diode discrete device shown in FIG. 2, FIG. 3, or FIG. 4.

Optionally, the diode discrete device 530 may include a first diode 532, a second diode 534, and a discrete device package body 536. The first diode 532 may be connected to a main circuit, and the second diode 534 may be connected to a bypass.

First performance of the first diode 532 may be better than first performance of the second diode 534, and the first performance includes a reverse recovery charge and reverse recovery time.

It should be noted that the first performance is switching performance of the diode.

Optionally, the first diode 532 may be a wide-bandgap semiconductor device, and the second diode 534 may be a silicon-based semiconductor device.

For example, the wide-bandgap semiconductor device may be a silicon carbide semiconductor device, or the wide-bandgap semiconductor device may be a gallium nitride semiconductor device.

Optionally, both the first diode 532 and the second diode 534 may be silicon-based semiconductor devices.

For example, the first diode 532 may be a silicon-based fast recovery diode, and the second diode 534 may be a silicon-based rectifier diode.

The first diode 532 and the second diode 534 may be packaged into the discrete device package body 536, and a cathode of the first diode 532 may also be connected to a cathode of the second diode 534.

In this embodiment of this application, the discrete device package body 536 may be a TO-247 package, the discrete device package body 536 may be a TO-220 package, the discrete device package body 536 may be a TO-263 package, or the discrete device package body 536 may be a TO-252 package.

Optionally, second performance of the second diode 534 may be better than second performance of the first diode 532, and the second performance may include at least one of a withstand voltage level, a conduction voltage drop, and a withstand current level.

In this embodiment of this application, the diode discrete device may include at least three electrodes.

Optionally, the cathode of the first diode 532 and the cathode of the second diode 534 may be connected to each other inside the discrete device package body 536 as shown in FIG. 2.

Alternatively, the diode discrete device may include four electrodes.

For example, the cathode of the first diode 532 and the cathode of the second diode 534 are connected to each other outside the discrete device package body 536.

FIG. 6 shows a buck (buck) circuit 600 with a bypass function according to an embodiment of this application. The circuit 600 may include an active switching device 610, an inductor 620, a diode discrete device 630, and a capacitor 640. The diode discrete device 630 may be the diode discrete device shown in FIG. 2, FIG. 3, or FIG. 4.

Optionally, the diode discrete device 630 may include a first diode 632, a second diode 634, and a discrete device package body 636. The first diode 632 may be connected to a main circuit, and the second diode 634 may be connected to a bypass.

First performance of the first diode 632 may be better than first performance of the second diode 634, and the first performance includes a reverse recovery charge and reverse recovery time.

It should be noted that the first performance is switching performance of the diode.

Optionally, the first diode 632 may be a wide-bandgap semiconductor device, and the second diode 634 may be a silicon-based semiconductor device.

For example, the wide-bandgap semiconductor device may be a silicon carbide semiconductor device, or the wide-bandgap semiconductor device may be a gallium nitride semiconductor device.

Optionally, both the first diode 632 and the second diode 634 may be silicon-based semiconductor devices.

For example, the first diode 632 may be a silicon-based fast recovery diode, and the second diode 634 may be a silicon-based rectifier diode.

The first diode 632 and the second diode 634 may be packaged into the discrete device package body 636, and an anode of the first diode 632 may be connected to an anode of the second diode 634.

In this embodiment of this application, the discrete device package body 636 may be a TO-247 package, the discrete device package body 636 may be a TO-220 package, the discrete device package body 636 may be a TO-263 package, or the discrete device package body 636 may be a TO-252 package.

Optionally, second performance of the second diode 634 may be better than second performance of the first diode 632, and the second performance may include at least one of a withstand voltage level, a conduction voltage drop, and a withstand current level.

In this embodiment of this application, the diode discrete device may include at least three electrodes.

Optionally, the anode of the first diode 632 and the anode of the second diode 634 may be connected to each other inside the discrete device package body 636 as shown in FIG. 3.

Alternatively, the diode discrete device may include four electrodes.

For example, the anode of the first diode 632 and the anode of the second diode 634 may be connected to each other outside the discrete device package body 636.

An embodiment of this application further provides a discrete device packaging method. The method specifically includes: packaging a first diode and a second diode into a same discrete device package body to obtain a diode discrete device.

The first diode may be a main circuit diode, the second diode may be a bypass diode, first performance of the first diode may be better than first performance of the second diode, the first performance may include a reverse recovery charge and reverse recovery time, the first diode and the second diode may be packaged into the same discrete device package body, and an anode of the first diode may be connected to an anode of the second diode, or a cathode of the first diode may be connected to a cathode of the second diode.

It should be noted that the first performance is switching performance of the diode.

Optionally, the first performance may further include a reverse recovery current.

Optionally, second performance of the second diode is better than second performance of the first diode, and the second performance may include at least one of a withstand voltage level, a conduction voltage drop, and a withstand current level.

Optionally, the first diode may be a wide-bandgap semiconductor device, and the second diode may be a silicon-based semiconductor device.

For example, the wide-bandgap semiconductor device is a silicon carbide semiconductor device, or the wide-bandgap semiconductor device is a gallium nitride semiconductor device.

Optionally, both the first diode and the second diode are silicon-based semiconductor devices.

Optionally, the diode discrete device includes at least three electrodes.

Optionally, the anode of the first diode and the anode of the second diode are connected to each other inside the discrete device package body; the cathode of the first diode and the cathode of the second diode are connected to each other inside the discrete device package body; the anode of the first diode and the anode of the second diode are connected to each other outside the discrete device package body; or the cathode of the first diode and the cathode of the second diode are connected to each other outside the discrete device package body.

Optionally, the discrete device package body may be a TO-247 package, the discrete device package body may be a TO-220 package, the discrete device package body may be a TO-263 package, or the discrete device package body may be a TO-252 package.

According to the discrete device packaging method, the diode discrete device shown in FIG. 2, FIG. 3, or FIG. 4 can be obtained by packaging the first diode and the second diode into the same discrete device package body.

The diode discrete device may be used in the circuits with the bypass function that are shown in FIG. 5 and FIG. 6. The diode discrete device can reduce an area and a volume of the circuit, thereby improving integration and power density of the circuit.

It should be understood that the term "and/or" in this specification indicates only an association relationship for describing associated objects and represents that three relationships may exist. For example, A and/or B may represent the following three cases: Only A exists, both A and B exist, and only B exists, where A and B may be singular or plural. In addition, the character "/" in this specification usually indicates an "or" relationship between associated objects, but may alternatively indicate a "and/or" relationship. For details, refer to the context for understanding.

In this application, "at least one" means one or more, and "a plurality of' means two or more. The term "at least one of the following items" or a similar expression means any combination of these items, including any combination of singular terms of plural items. For example, at least one of a, b, or c may indicate a, b, c, a and b, a and c, b and c, or a, b, and c, where a, b, and c may be singular or plural.

It should be understood that sequence numbers of the foregoing processes do not mean execution sequences in the embodiments of this application. The execution sequences of the processes should be determined based on functions and internal logic of the processes, and should not be construed as any limitation on the implementation processes of the embodiments of this application.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A diode discrete device, wherein the diode discrete device is used in a circuit with a bypass function, and the diode discrete device comprises:
a discrete device package body, a first diode, and a second diode, wherein
the first diode is a main circuit diode, the second diode is a bypass diode, first performance of the first diode is better than first performance of the second diode, and the first performance comprises a reverse recovery charge and reverse recovery time; and
the first diode and the second diode are packaged into the discrete device package body, and an anode of the first diode is connected to an anode of the second diode, or a cathode of the first diode is connected to a cathode of the second diode.

2. The diode discrete device according to claim 1, wherein second performance of the second diode is better than second performance of the first diode, and the second performance comprises at least one of a withstand voltage level, a conduction voltage drop, and a withstand current level.

3. The diode discrete device according to claim 1 or 2, wherein the first diode is a wide-bandgap semiconductor device, and the second diode is a silicon-based semiconductor device.

4. The diode discrete device according to claim 3, wherein the wide-bandgap semiconductor device is a silicon carbide semiconductor device, or the wide-bandgap semiconductor device is a gallium nitride semiconductor device.

5. The diode discrete device according to claim 1 or 2, wherein both the first diode and the second diode are silicon-based semiconductor devices.

6. The diode discrete device according to any one of claims 1 to 5, wherein the diode discrete device comprises at least three electrodes.

7. The diode discrete device according to any one of claims 1 to 6, wherein
the anode of the first diode and the anode of the second diode are connected to each other inside the discrete device package body;
the cathode of the first diode and the cathode of the second diode are connected to each other inside the discrete device package body;
the anode of the first diode and the anode of the second diode are connected to each other outside the discrete device package body; or
the cathode of the first diode and the cathode of the second diode are connected to each other outside the discrete device package body.

8. The diode discrete device according to any one of claims 1 to 7, wherein the discrete device package body is a TO-247 package, the discrete device package body is a TO-220 package, the discrete device package body is a TO-263 package, or the discrete device package body is a TO-252 package.

9. A circuit with a bypass function, wherein the circuit comprises:
a main circuit, a bypass, and a diode discrete device used in the circuit, wherein
the diode discrete device comprises a discrete device package body, a first diode, and a second diode, the first diode is connected to the main circuit, and the second diode is connected to the bypass;
first performance of the first diode is better than first performance of the second diode, and the first performance comprises a reverse recovery charge and reverse recovery time; and
the first diode and the second diode are packaged into the discrete device package body, and an anode of the first diode is connected to an anode of the second diode, or a cathode of the first diode is connected to a cathode of the second diode.

10. The circuit according to claim 9, wherein second performance of the second diode is better than second performance of the first diode, and the second performance comprises at least one of a withstand voltage level, a conduction voltage drop, and a withstand current level.

11. The circuit according to claim 9 or 10, wherein the first diode is a wide-bandgap semiconductor device, and the second diode is a silicon-based semiconductor device.

12. The circuit according to claim 11, wherein the wide-bandgap semiconductor device is a silicon carbide semiconductor device, or the wide-bandgap semiconductor device is a gallium nitride semiconductor device.

13. The circuit according to claim 9 or 10, wherein both the first diode and the second diode are silicon-based semiconductor devices.

14. The circuit according to any one of claims 9 to 13, wherein the diode discrete device comprises at least three electrodes.

15. The circuit according to any one of claims 9 to 14, wherein
the anode of the first diode and the anode of the second diode are connected to each other inside the discrete device package body;
the cathode of the first diode and the cathode of the second diode are connected to each other inside the discrete device package body;
the anode of the first diode and the anode of the second diode are connected to each other outside the discrete device package body; or
the cathode of the first diode and the cathode of the second diode are connected to each other outside the discrete device package body.

16. The circuit according to any one of claims 9 to 15, wherein the discrete device package body is a TO-247 package, the discrete device package body is a TO-220 package, the discrete device package body is a TO-263 package, or the discrete device package body is a TO-252 package.

17. A converter, wherein the converter comprises at least one diode discrete device, and the diode discrete device comprises a discrete device package body, a first diode, and a second diode, wherein
the first diode is a main circuit diode, the second diode is a bypass diode, first performance of the first diode is better than first performance of the second diode, and the first performance comprises a reverse recovery charge and reverse recovery time; and
the first diode and the second diode are packaged into the discrete device package body, and an anode of the first diode is connected to an anode of the second diode, or a cathode of the first diode is connected to a cathode of the second diode.

18. The converter according to claim 17, wherein second performance of the second diode is better than second performance of the first diode, and the second performance comprises at least one of a withstand voltage level, a conduction voltage drop, and a withstand current level.

19. The converter according to claim 17 or 18, wherein the first diode is a wide-bandgap semiconductor device, and the second diode is a silicon-based semiconductor device.

20. The converter according to claim 19, wherein the wide-bandgap semiconductor device is a silicon carbide semiconductor device, or the wide-bandgap semiconductor device is a gallium nitride semiconductor device.

21. The converter according to claim 17 or 18, wherein both the first diode and the second diode are silicon-based semiconductor devices.

22. The converter according to any one of claims 17 to 21, wherein the diode discrete device comprises at least three electrodes.

23. The converter according to any one of claims 17 to 22, wherein
the anode of the first diode and the anode of the second diode are connected to each other inside the discrete device package body;
the cathode of the first diode and the cathode of the second diode are connected to each other inside the discrete device package body;
the anode of the first diode and the anode of the second diode are connected to each other outside the discrete device package body; or
the cathode of the first diode and the cathode of the second diode are connected to each other outside the discrete device package body.

24. The converter according to any one of claims 17 to 23, wherein the discrete device package body is a TO-247 package, the discrete device package body is a TO-220 package, the discrete device package body is a TO-263 package, or the discrete device package body is a TO-252 package.

25. A discrete device packaging method, comprising:
packaging a first diode and a second diode into a same discrete device package body to obtain a diode discrete device, wherein
the first diode is a main circuit diode, the second diode is a bypass diode, first performance of the first diode is better than first performance of the second diode, the first performance comprises a reverse recovery charge and reverse recovery time, the first diode and the second diode are packaged into the same discrete device package body, and an anode of the first diode is connected to an anode of the second diode, or a cathode of the first diode is connected to a cathode of the second diode.

26. The packaging method according to claim 25, wherein second performance of the second diode is better than second performance of the first diode, and the second performance comprises at least one of a withstand voltage level, a conduction voltage drop, and a withstand current level.

27. The packaging method according to claim 25 or 26, wherein the first diode is a wide-bandgap semiconductor device, and the second diode is a silicon-based semiconductor device.

28. The packaging method according to claim 27, wherein the wide-bandgap semiconductor device is a silicon carbide semiconductor device, or the wide-bandgap semiconductor device is a gallium nitride semiconductor device.

29. The packaging method according to claim 25 or 26, wherein both the first diode and the second diode are silicon-based semiconductor devices.

30. The packaging method according to any one of claims 25 to 29, wherein the diode discrete device comprises at least three electrodes.

31. The packaging method according to any one of claims 25 to 30, wherein
the anode of the first diode and the anode of the second diode are connected to each other inside the discrete device package body;
the cathode of the first diode and the cathode of the second diode are connected to each other inside the discrete device package body;
the anode of the first diode and the anode of the second diode are connected to each other outside the discrete device package body; or
the cathode of the first diode and the cathode of the second diode are connected to each other outside the discrete device package body.

32. The packaging method according to any one of claims 25 to 31, wherein the discrete device package body is a TO-247 package, the discrete device package body is a TO-220 package, the discrete device package body is a TO-263 package, or the discrete device package body is a TO-252 package.
